(19) 

**Europäisches Patentamt**
**European Patent Office**
**Office européen des brevets**

(11) **EP 3 343 389 B1**

(12) **EUROPEAN PATENT SPECIFICATION**

(45) Date of publication and mention
of the grant of the patent:
**21.12.2022 Bulletin 2022/51**

(21) Application number: **16382671.2**

(22) Date of filing: **29.12.2016**

(51) International Patent Classification (IPC):
**B60L 58/12** (2019.01)  **G01R 31/36** (2020.01)

(52) Cooperative Patent Classification (CPC):
**G06F 17/13; B60L 58/12; B60L 58/16;
G01R 31/367; G01R 31/382;** B60L 2240/54;
B60L 2240/545; B60L 2240/547; B60L 2260/44;
Y02T 10/70

(54) **METHOD FOR THE CALCULATION OF AN OPEN-CIRCUIT VOLTAGE OF AN ENERGY ACCUMULATOR, AND ASSOCIATED GRAPHIC REPRESENTATION DEVICE**

VERFAHREN ZUR BERECHNUNG EINER LEERLAUFSPANNUNG EINES ENERGIEAKKUMULATORS UND ZUGEHÖRIGE GRAFIKDARSTELLUNGSVORRICHTUNG

PROCÉDÉ DE CALCUL D'UNE TENSION DE CIRCUIT OUVERT D'UN ACCUMULATEUR D'ÉNERGIE ET DISPOSITIF ASSOCIÉ DE REPRÉSENTATION GRAPHIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.07.2018 Bulletin 2018/27**

(73) Proprietor: **Seat, S.A.**
**08760 Martorell (ES)**

(72) Inventors:
• **Viñolo Monzoncillo, Carlos**
**08760 Martorell (ES)**
• **Biel Solé, Domingo**
**08760 Martorell (ES)**

(74) Representative: **Elzaburu S.L.P.**
**Edificio Torre de Cristal**
**Paseo de la Castellana 259 C, planta 28**
**28046 Madrid (ES)**

(56) References cited:
**US-A1- 2015 219 726     US-B1- 6 534 954**

• **LIEVRE AURELIEN ET AL: "Luenberger observer for SoC determination of lithium-ion cells in mild hybrid vehicles, compared to a Kalman filter", 2015 TENTH INTERNATIONAL CONFERENCE ON ECOLOGICAL VEHICLES AND RENEWABLE ENERGIES (EVER), IEEE, 31 March 2015 (2015-03-31), pages 1-7, XP032780626, DOI: 10.1109/EVER.2015.7112986 [retrieved on 2015-05-26]**
• **TAESIC KIM ET AL: "Real-time state of charge and electrical impedance estimation for lithium-ion batteries based on a hybrid battery model", APPLIED POWER ELECTRONICS CONFERENCE AND EXPOSITION (APEC), 2013 TWENTY-EIGHTH ANNUAL IEEE, IEEE, 17 March 2013 (2013-03-17), pages 563-568, XP032410393, DOI: 10.1109/APEC.2013.6520266 ISBN: 978-1-4673-4354-1**
• **YANG FANGFANG ET AL: "A comparative study of three model-based algorithms for estimating state-of-charge of lithium-ion batteries under a new combined dynamic loading profile", APPLIED ENERGY, ELSEVIER SCIENCE PUBLISHERS, GB, vol. 164, 22 December 2015 (2015-12-22), pages 387-399, XP029386944, ISSN: 0306-2619, DOI: 10.1016/J.APENERGY.2015.11.072**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- LINFENG ZHENG ET AL: "Embedded implementation of SOC estimation based on the Luenberger observer technique", 2014 IEEE CONFERENCE AND EXPO TRANSPORTATION ELECTRIFICATION ASIA-PACIFIC (ITEC ASIA-PACIFIC), IEEE, 31 August 2014 (2014-08-31), pages 1-4, XP032671532, DOI: 10.1109/ITEC-AP.2014.6941037 [retrieved on 2014-10-31]
- LIU ZHENTONG ET AL: "Structural analysis based sensors fault detection and isolation of cylindrical lithium-ion batteries in automotive applications", CONTROL ENGINEERING PRACTICE, PERGAMON PRESS, OXFORD, GB, vol. 52, 19 April 2016 (2016-04-19), pages 46-58, XP029545446, ISSN: 0967-0661, DOI: 10.1016/J.CONENGPRAC.2016.03.015

## Description

## SUBJECT OF THE INVENTION

The subject of the present patent application is a method for estimating a state of charge of an energy accumulator according to claim 1, which incorporates advantages of precision and speed of calculation. The invention also relates to a data processing device according to claim 8, and to a computer programme according to claim 11.

## ANTECEDENTS OF THE INVENTION

At present the need exists in the motor vehicle industry to determine internal characteristics of a battery, for greater control and precision of the energy efficiency. However, some of these characteristics cannot be measured directly during the use of the battery, or also for a short time after its latest use, and this prevents the results obtained on the basis of direct measurements from being precise and certain. Some of the internal characteristics of the battery cannot be measured during driving, since a current flow exists which involves internal chemical reactions which mask these characteristics. Thus, there is a need to provide a calculation method in order to determine at least one of the said characteristics, particularly the open-circuit voltage of the battery, including in situations in which the energy accumulator is not in an ideal situation for the measurement.

In some ideal conditions or situations, the relationship between the measurable characteristics of a battery and those which are not measurable is direct. This assists the fact that, in these situations, it is possible to succeed in determining internal characteristics of the battery using exclusively measurements which are available, or in other words, measurements which can be measured directly.

However, when the conditions or situations are not ideal, the measurable characteristics cease to have a direct relationship with the non-measurable characteristics. Consequently, it is necessary to find a method which can relate the measurable and non-measurable characteristics in any situations or conditions, such that the results never cease being reliable.

Measurable characteristics mean all the physical variables which can be determined by means of the general sensors or sensing means of the vehicle, which in this case, and without being exclusive of others, would be the: voltage, current or $T^a$ (temperature), etc.

Non-measurable characteristics mean all the functions which are not determined directly by means of the general sensors or sensing means of the vehicle, which in this case, and without being exclusive of others, would be the: SoC (State of Charge) of the battery, internal losses from the battery, etc.

In addition, there is another type of characteristics which in certain ideal situations can be measured, and which however, when these situations change, are converted into non-measurable characteristics, such as, for example, and without excluding other characteristics, the open-circuit voltage function $V_{ocv}$.

"Method capable of relating these types of characteristics" means all the descriptive functions which can relate the behaviour of the measurable characteristics to the non-measurable characteristics with a certain degree of precision in the long term, for example a mathematical model.

Thus, the ideal situation for measurement of characteristics of the energy accumulator or battery is considered to be the one in which there has not been an exchange of energy, in other words a current flow equal to zero, for a specific period of time. In particular, with reference to the motor vehicle field, this situation is associated with the one in which the vehicle is stationary.

Finally, a non-ideal situation is considered to be any case other than that previously described. In particular, with reference to the motor vehicle field, this situation is associated with that in which the vehicle is running, or when the battery is in use, or also in a state in which the vehicle is stationary and little time has elapsed since its latest use. In these situations, the prior state of use of the energy accumulator may not be known because of a stoppage of the processing units of the vehicle at the time of parking. If, when these processing units are restarted, the energy accumulator is not in a known state, in which this known state would be equivalent to an ideal situation, the calculation of, in this case and by way of non-limiting example, the voltage $V_{ocv}$, cannot be carried out directly. Although the energy accumulator model is known, the calculation cannot be carried out directly because of lack of information about the state of this energy accumulator.

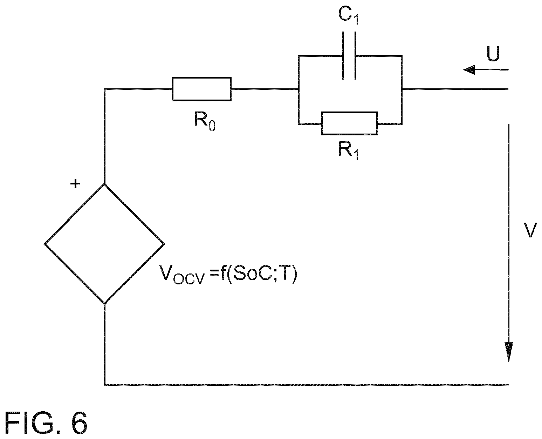

A very simple mathematical model which relates measurable characteristics to non-measurable characteristics of an energy accumulator or battery would be a circuit constituted by a source of voltage $V_{ocv}$, this voltage $V_{ocv}$ being according to the SoC and the $T^a$, with a resistor $R_0$ in series, and in turn other impedance in series constituted by two passive elements in parallel, $C_1$ and $R_1$, with $R_0$, $R_1$ and $C_1$ being functions of the SoC and the $T^a$, and not constant parameters. This circuit would be supplied by a current U. This model is represented schematically in figure 6.

This model is extremely non-linear, since its descriptive functions necessary to relate the measurable and non-measurable characteristics have parameters which also depend on these characteristics. In addition, the voltage $V_{ocv}$ which appears in the output equation of the mathematical model impedes the direct implementation of methods which are known in the prior art.

The calculation of the state of charge (SoC) of the battery is always related in some way to the voltage $V_{ocv}$. In an ideal situation, this open-circuit voltage ($V_{ocv}$) is directly related to the battery voltage (V). However, outside this ideal situation, estimation of the voltage $V_{ocv}$ is not easy, since it depends on each type of energy accumulator, the temperature, and also the level of use to which this energy accumulator has been subjected. The direct equation which calculates $V_{ocv}$ by means of the model previously described is: $V_{ocv} = V - \eta 0 - \eta 1$, where V is the battery voltage, $\eta 0$ is the excess voltage in the resistor R0, and $\eta 1$ is the excess voltage in the passive element R1. Because of the mathematical description of this function, it is necessary to know the at least one variable of state of the battery model, which involves having to know the conditions of the battery itself at the moment which coincides with the start of calculation of the functions of the model (initial conditions).

If these initial conditions described cannot be determined, then the calculation of the functions of the model does not make it possible functionally to succeed in determining the $V_{ocv}$. These initial conditions are not known in the motor vehicle field when the situation is not ideal at the moment when calculation of the function is begun, i.e. when the vehicle is started before the battery has been able to reach a complete state of relaxation, in other words when it has been switched off and switched on in a given period of time (ranging from minutes to hours), or when the vehicle is being driven.

At present there are not many techniques which estimate the value of $V_{ocv}$ in another way, and those which do use direct conversion tables using the SoC, which is risky if in turn good estimation of the state of charge is not available. Other methods use quite complex non-linear techniques with mathematical approximations which are not always certain, or which cannot be implemented because of their complexity. For example, a quite common but complex technique consists of the use of Kalman filters and their non-linear variants (extended Kalman filters, etc.) in order to extract the function $V_{ocv}$. This technique can involve complex challenges, and a lack of reliability in some applications.

In addition, a method is known in the prior art, as reflected in document US20150219726, for estimating the state of charge of a battery which uses a model of the battery based on a multi-RC electric circuit designed to represent an open-circuit voltage and/or an impedance of a battery. A state observer can be used in relation with the estimation of parameters associated with the battery model. This methodology is based on the estimation of some of the parameters of the electric model of the battery. Impedance calculation is used based on FFT (fast Fourier transformations) at various frequencies and a Luenberger observer in order to correct the impedances. The function $V_{ocv}$ can be obtained from the calculation of the SoC, and a table of the LUT type (look-up table, or static tables) previously estimated, or by means of any other method. The initial conditions of the model are assumed to be known.

A device is also known according to the prior art, as reflected in document US8099180, for the determination of variables of state and/or parameters of a mathematical model of an energy accumulator, the electric properties of which are described on the basis of various variables of state and parameters. The mathematical model of the energy accumulator has correction equations by means of which the variables of state and/or the parameters are corrected and adjusted using the error between the voltage measurement of the energy accumulator and the voltage measurement of the model. This error is divided into different individual components equivalent to a proportional factor, a derivative factor, and another integral one, which are weighted using a weighting factor.

The use of the same components to adjust both the parameters of the model and its states does not make the viability of this technique apparent, and the design criteria for its implementation lack rigorousness, meaning that the applicability of this technique is unclear.

An apparatus is also known in the prior art, as reflected in document EP0505333, for the continuous estimation of the charge of electrochemical lead batteries, which apparatus includes data recognition means for the measurement of the battery voltage, the current and the ambient temperature. It comprises a system for conditioning and conversion for the signals of these data recognition means, as well as a data processing system which is designed to provide information and any control signal with respect to all the operating parameters of the battery with reference to a predetermined dynamic model, in order to be able to simulate the performance of this battery. The battery charge is corrected by means of the error signals, according to the difference between the voltage measured and the estimated voltage obtained from a control or observer structure.

Thus, this method focuses on estimating the remaining charge in the battery, and not on carrying out a prior estimation of $V_{ocv}$. In addition, it is important to indicate the following points:

- In cases in which the initial conditions of the model are not known, the system is slow and inaccurate (even more so in batteries where the dynamics are generally slow). The reason is that the control structure, which permits correction of the error, is implemented once the voltage value $V_{ocv}$ has been obtained, which affects obtaining of the estimated charge value, thus requiring many iterations in order to obtain a precise value.
- According to the type of battery analysed, the estimation method according to the invention can take many minutes to obtain an estimated charge value which converges towards the real charge value.
- In order for the estimated charge value to be precise, the method according to the invention must be processed and iterated continually. Once the estimated charge value is substantially equal to the real charge of the battery, the method according to the present invention requires continuous processing. Otherwise, the estimated charge would become distanced from the real value, once again requiring a long time until the estimated charge value converges towards that of the real charge. As previously stated, the motive will be to start once again with initial conditions which are not known, and to apply control of correction of the error outside the load estimation model.

There is also known in the prior art, as reflected in document US7109685, a method for estimation of a state of charge (SoC) and a state of health (SoH) of an electrochemical cell (CE), which includes modelling of the electrochemical cell in a linear equation, measurement of a terminal current of the electrochemical cell, measurement of a voltage at the terminals of the electrochemical cell, and measurement of a temperature of the electrochemical cell. The linear equation is processed by means of a state estimator and parameters using the aforementioned measurements.

The method in question is based on the Kalman filter variant, wherein both parameters and states are estimated. If the states are known, the estimation of $V_{ocv}$ is direct, since the problem of the ideal/non-ideal cases is solved. The disadvantages of this method consist of the complexity involved, particularly at the time of implementation, and the compromise between complexity and precision. For methods based on Kalman filters which are not so complex, a series of parameters is necessary for correct functioning (e.g. a matrix of covariance of the process). If these parameters are not precise, the method does not work well.

D1 (Luenberger observer for SoC determination of lithium-ion cells in mild hybrid vehicles, compared to a Kalman filter, Published in: 2015 Tenth International Conference on Ecological Vehicles and Renewable Energies (EVER), IEEE, 31 March 2015 (2015-03-31), pages 1-7, XP032780626, DOI: 10.1109/EVER.2015.7112986, describes a Li-ion batteries are continually developed for a wide range of use. New variants appear on the market, including Li-ion technologies that allow supplying very high electrical power. By consequence, the battery can be used as an energy buffer in vehicles. The autonomy is limited, and it is necessary to determine the State of Charge of each element that makes up a battery, although these elements (Li-ion cells) are never fully discharged or charged. In this unusual context, a solution may be to use a Kalman filter at the cost of significant computing power. More computation-wise economical observers can beings used, in particular Luenberger observers. The results obtained for this type of specific use, give similar final results, with a significant gain on the computing power required.

Thus, it can be seen that there is still a need to have a method for calculation of an open-circuit voltage of an energy accumulator and associated graphic representation device such that a precise and rapid result is obtained in the estimation of the voltage $V_{ocv}$, even when there are errors in the estimations of the model because the initial states are not known. In addition, it is wished to reduce the complexity of the known models and reduce the processing resources required by the control unit.

This means that this estimation can be carried out for example during driving, without this altering either the precision or the reliability of the results.

## SUMMARY

The invention is set out in the appended set of claims.

The present invention consists of a method for estimation of the function $V_{ocv}$ or open-circuit voltage of an energy accumulator in any type of situation, for possible subsequent use in the correction of the estimation of the state of charge of the accumulator. It is understood, more specifically, but not restrictively, that the energy accumulator is a battery or a battery cell of a motor vehicle. It is also understood that the situation can be both ideal and non-ideal. By way of non-limiting example, an ideal situation is that in which the motor vehicle is stationary, and sufficient time has elapsed since its latest use for the intrinsic electrochemical reactions of the battery to reach a stationary state. It should be noted that many of the models known in the prior art are valid only in order to estimate the function $V_{ocv}$ in an ideal situation, i.e. in which the initial conditions are known.

Alternatively, the present invention provides a method for estimation of the function $V_{ocv}$ both in ideal and non-ideal situations, i.e. by way of non-limiting example, a non-ideal situation is that in which the motor vehicle is running, or is stationary but has only been so for a short time since its latest use, such that there is a current circulating through its battery circuit, and/or intrinsic electrochemical reactions of the battery. A non-ideal situation therefore means that in which the initial conditions or initial state are not known. It should be noted that these situations are very common in the automotive industry. In addition, the present invention is resistant to parameterisation errors in some of the descriptive parameters of the model of the energy accumulator.

The invention will be described with reference to the appended drawings which show by way of non-limiting example a method for calculation of an open-circuit voltage of an energy accumulator, and associated graphic representation device, constituted according to the invention. Other characteristics and advantages of this method for calculation of an open-circuit voltage of an energy accumulator, and associated graphic representation device which are the subject of the present invention, will become apparent from the description of a preferred, but not exclusive embodiment, which is illustrated by way of non-limiting example in the accompanying drawings, in which:

## BRIEF DESCRIPTION OF THE DRAWINGS

Figure 1 is a lateral view of a vehicle which comprises two energy accumulators according to the present invention.

Figure 2 is a graphic representation of a possible electric current *u*, according to the present invention.

Figure 3 is a graphic representation of a possible open-circuit voltage of the energy accumulator $V_{ocv}$, according to the present invention.

Figure 4A is a representation of the main equations which follows the method according to the present invention.

Figure 4B is a detailed graphic representation of one of the periods during which the measurement of the function $V_{ocv}$ is estimated according to the method of the present invention.

Figure 5 is a graphic representation which compares the estimation of the function $V_{ocv}$ by means of a methodology known in the prior art and the method according to the present invention.

Figure 6 is a graphic representation of a generic first-order model of an energy accumulator based on a wiring diagram.

## DESCRIPTION OF THE INVENTION

In the light of the aforementioned figures, and in accordance with the numbering adopted, an example can be seen of a preferred embodiment of the invention, comprising the parts and elements which are indicated and described in detail hereinafter.

This method for estimation of the function $V_{ocv}$ or open-circuit voltage 10 of an energy accumulator 2 is based on the structure of at least one Luenberger observer, which is the basic structure of a states observer of a linear system. In order to overcome the nonlinearities of the system, the descriptive parameters of the energy accumulator model 2 are described by means of linearised functions around work points which are normally dependent on the temperature measurement and the estimation of the state of charge of the energy accumulator. The function $V_{ocv}$ is observed using a Luenberger structure which is combined in an innovative manner. This combined structure makes it possible to observe the function $V_{ocv}$ without prior knowledge of the initial state of the battery or energy accumulator 2. It is carried out without needing any uncertain or approximate mathematical approximation. Note the simplicity of the structure, which makes possible its technical viability in relation to the present technology.

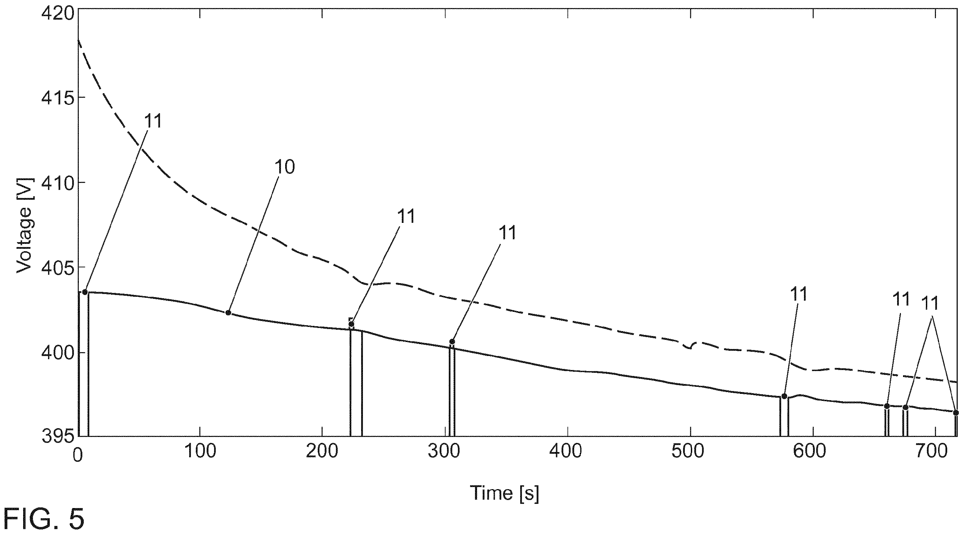

Thus, and by way of example, the graphic representation in figure 5 is presented, showing a comparison of the open-circuit voltage 10 according to methods known in the prior art and the method according to the present invention. Thus, a discontinuous line represents the estimation of $V_{ocv}$ by means of other methods based exclusively on a mathematical model of the energy accumulator, which does not include any control structure. Thus, this estimation is based on an electric accumulator model with 20% error in the parameters of the matrix B, and with lack of knowledge of the initial conditions. In addition, a continuous fine line represents the real value of $V_{ocv}$. Finally, a continuous thick line represents the open-circuit voltage $V_{ocv}$ 11 estimated by means of the method according to the present invention, with the same conditions of 20% error in the parameters of the matrix B, and with lack of knowledge of the initial conditions. The lower shaded portion below each estimation of the function $V_{ocv}$ by means of the method according to the present invention represents the time during which the calculation process is executed.

Thus, and as shown in figure 5, the objective of the method according to the present invention is to carry out an estimation of an open-circuit voltage 10 of an energy accumulator 2 with minimisation of the processing resources or consumption of resources by the control unit or data processing device and overcoming of the possible errors of the descriptive parameters of the accumulator model. This estimation is used subsequently in order to correct the calculation of the state of charge of the energy accumulator, which can be carried out continuously by means of methods which are simple but prone to cumulative errors, already established, such as, and without excluding others, the Coulomb Counting method.

Consequently, only intermittent corrections of the charge of the energy accumulator 2 are required. Therefore, periodic corrections of the state of charge are carried out by means of the estimation results obtained by means of the method according to the present invention and a characteristic table which relates the open-circuit voltage ($V_{ocv}$) to the state of charge. Thus, a method is obtained which does not require continuous processing in order to obtain an estimated charge value which converges towards the real charge value and carries out only intermittent corrections which succeed in solving the problem of the unknown initial conditions (non-ideal situations), and that of the imprecise parameters of the model. The following points can be distinguished:

-     A period of time of a few milliseconds is required by the present method to obtain a charge value which converges toward the real charge value. By this means, and advantageously, at intermittent moments and very short intervals of time, it will be possible to correct the charge value of the energy accumulator 2.

-     The method according to the present invention is executed when the function $V_{ocv}$ or open-circuit voltage 10 is constant, by way of example when the motor vehicle 1 is stopped or the energy accumulator is not used during driving (by way of example situations in which acceleration or braking do not take place). It will be at this time that the method is executed for the purpose of correcting the charge of the energy accumulator 2.

It is also observed that there is minimisation of the consumption of resources required in order to execute the method according to the present invention, by limiting it only to intermittent moments which make it possible to obtain a estimated charge value that converges towards the real charge value, consequently correcting at this time the charge value of the energy accumulator 2 obtained by means of other simple methods which require corrections.

Thus, the present invention consists specifically of a method for calculation of an open-circuit voltage 10 of an energy accumulator 2, which comprises the following steps:

i) considering definition of the energy accumulator 2 according to a system of equations and a plurality of descriptive parameters in accordance with the following equation:

$$\dot{x} = Ax + Bu$$

$$V = Cx + Vocv + Du$$

where $x$ is a variable which defines at least one state of the energy accumulator 2, $\dot{x}$ is the temporal derivative of the variable which defines at least one state of the energy accumulator 2 $x$, A, B, C and D are a plurality of matrices which constitute the performance of the energy accumulator 2, $u$ is a measurement of electric current 3 which circulates through the energy accumulator 2, $V$ is a voltage measured at the terminals of the energy accumulator 21, and $V_{ocv}$ is an open-circuit voltage 10 of the energy accumulator 2;

ii) obtaining the measurement of the electric current $u$ 3 which circulates through the energy accumulator 2;

iii) determining on the basis of the electric current measurement $u$ 3 obtained that the open-circuit voltage 10 $V_{ocv}$ of the energy accumulator 2 is constant for a predetermined period of time;

iv) obtaining the voltage measured at the terminals of the energy accumulator $V$ 21;

v) calculating an estimated voltage at the terminals of the energy accumulator $\hat{V}$ 22 by means of an observer 41, wherein the observer 41 is defined by means of a specific control structure;

vi) calculating the open-circuit voltage $V_{ocv}$ 10 of the energy accumulator 2 by means of the formula:

$$V_{ocv} = e_{\hat{V}}\left[\left(CI(A - KC)^{-1}K\right) + 1\right]^{-1}$$

where $e_{\hat{V}}$ is a signal 20 which depends on a difference between the voltage measured at the terminals of the energy accumulator $V$ 21 and the voltage estimated at the terminals of the energy accumulator

$\hat{V}$ 22 by the observer 41, and $K$ is a variable 61 which defines a time of convergence of the calculation of the open-circuit voltage of the energy accumulator $V_{ocv}$ 10 by means of the observer 41.

As previously stated, the energy accumulator 2 has been defined in accordance with the model in figure 6.

Advantageously, this method is valid for both ideal and non-ideal situations, since the result of $V_{ocv}$ continues to be precise including when the energy accumulator 2, or battery, or battery cell, is not in an ideal situation (e.g., with the engine running during driving, i.e. with current passing through it). It is also possible that, because of the ageing of the energy accumulator, the parameters B and D of the model may be affected by an incremental error over a period of time. Since this methodology is executed at moments when the electric current is null, the errors in these parameters do not affect the convergence result of $V_{ocv}$. It should be noted that although reference is made generically to an energy accumulator 2, this is applicable to a battery or a cell of this battery.

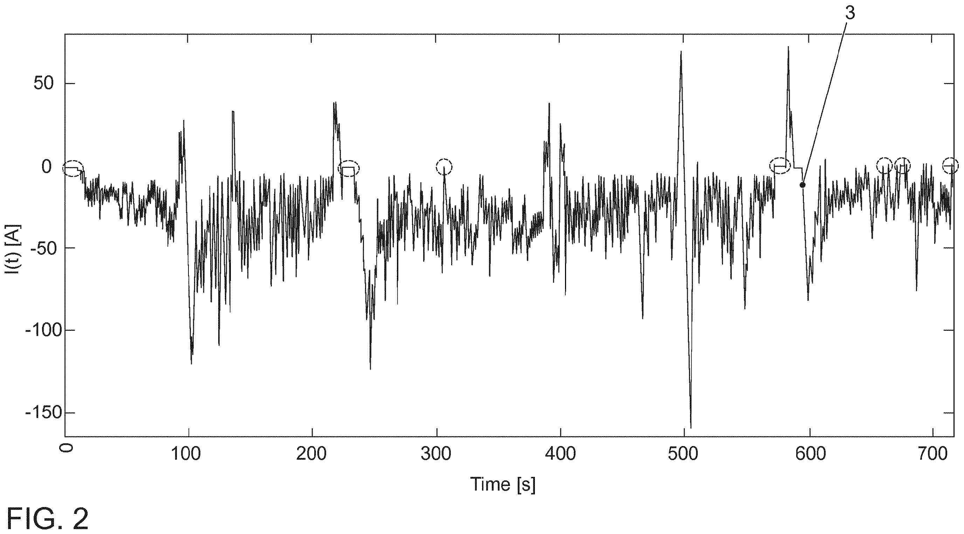

Figure 2 shows an example of demand for electricity by a plurality of electrical consumers of a motor vehicle 1 during a period of driving and shows the value of the electric current supplied by the energy accumulator 2. This figure shows by means of circles with broken lines the moments in time when the current supplied is zero.

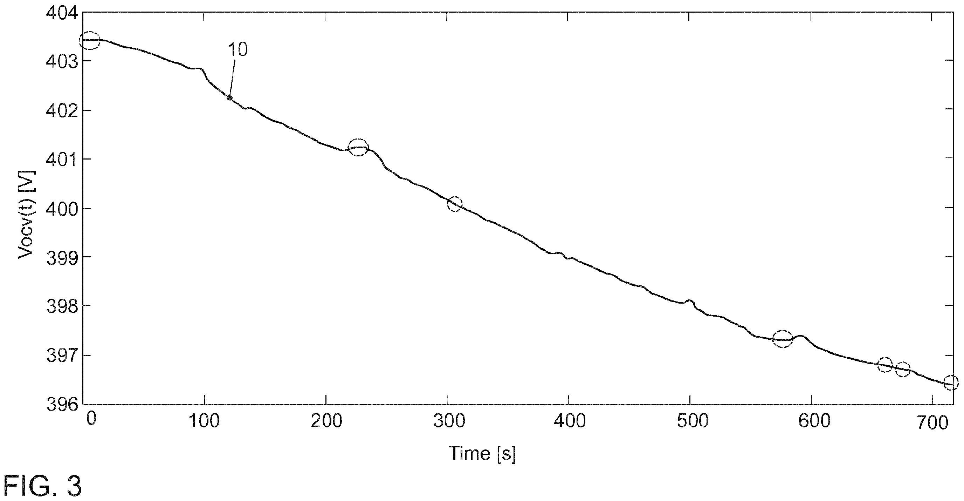

In addition, figure 3 shows the moments in time when the open-circuit voltage 10 is constant. These are the moments in time which coincide with the moments when the current measurement 3 is zero, as shown in figure 2. This figure shows by means of circles with broken lines the moments in time when the open-circuit voltage 10 is constant.

According to an embodiment which not fall under the scope of the present invention, the step of determining the constant open-circuit voltage 10 $V_{ocv}$ of the constant energy accumulator 2 consists of obtaining a value of the electric current measurement $u$ 3 which is close to zero. Value of the electric current measurement u 3 which is close to zero means when the current supplied by the energy accumulator 2 is very low compared with its capacity. Reference is then made to an electric current measurement u 3 which is close to zero or substantially null obtained during the predetermined period of time.

An example where the electric current value $u$ 3 comprises a value which is close to zero is when an electric vehicle is stopped, or no energy is being supplied to the propulsion system of this vehicle. Thus, small consumers such as control units continue to function, since this consumption is very low in comparison with the capacity of the energy accumulator 2. In an example such as the one previously presented, the matrices A, B, C and D of the mathematical model of the energy accumulator 2 must be known.

According to the present invention, the step of determining the constant open-circuit voltage 10 $V_{ocv}$ of the energy accumulator 2 consists of obtaining a value of the electric current measurement u 3 which is equal to zero. It should then be noted that the zero value of the electric current measurement $u$ 3 signifies a null value, i.e. when no energy accumulator 2 consumer exists. The step consists of observing, from amongst the electric current measurements 3 obtained, those which have a null value. When the value of the electric current measurement 3 is kept at null during the predetermined period of time, this means that the open-circuit voltage 10 of the energy accumulator 2 remains constant. It will be at this moment that the following steps described in the present method will be carried out. By way of example, the electric current measurements 3 are null when the motor vehicle 1 is switched off.

Another example is a motor vehicle 1 of a hybrid type, where the electric vehicle is being driven by the combustion engine, and therefore the energy accumulator 2 which supplies the electric drive motor is not supplying current. The electronics of the vehicle, or other electrical consumers, are supplied by another source of supply, such as another battery. In this case, the value of the electric current $u$ 3 measured is equal to zero. In an example such as the one presented previously, the matrices A and C of the mathematic model of the energy accumulator 2 must be known. On the other hand, the matrices B and D can be partially unknown, with a certain error in their estimation.

According to another aspect of the present invention, obtaining the value of the electric current measurement $u$ 3 which is equal to zero consists of forcing an interruption of a first electrical supply by the energy accumulator 2 during the predetermined period of time. Thus, by forcing the interruption of the first electrical supply, the electric current measurement $u$ 3 will be equal to zero, and the method according to the present invention can be executed.

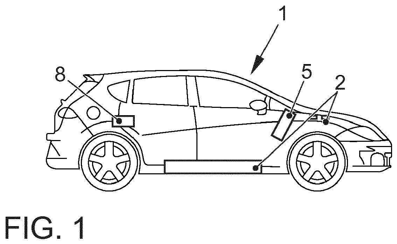

More particularly, forcing the interruption of the first electrical supply by the energy accumulator 2 consists of providing a second electrical supply by means of an additional device 8 during the predetermined period of time, such that an electric current supplied by the energy accumulator 2 and by the additional device 8 is continuous. This then means that, for the purpose of countering the interruption of the electrical supply of the energy accumulator 2, the second electrical supply is enabled by the additional device 8, which can be another battery integrated in the motor vehicle 1, as shown in figure 1. It should be remembered that the current supplied is a value close to zero, such that the additional device 8 has a reduced or limited capacity.

By this means, the method according to the present invention can gather the function $V_{ocv}$ even when the initial conditions are not known, i.e. with the battery or energy accumulator 2 in a state which is not relaxed at the moment when this method begins to be executed.

In the case of the present invention, a structure is used which is based on a Luenberger observer, the combination of the output error of which $e_{\hat{V}}$, defined as $(V - \hat{V})$ is equal to the function $V_{ocv}$ of the energy accumulator 2 once the stationary state has been reached (which state is established after a certain period of time, normally of approximately a second).

The terms used are defined as follows:

$x$ is a variable which defines at least one state of the energy accumulator 2;

$\dot{x}$ is the temporal derivative of the variable which defines at least one state of the energy accumulator 2,

$V$ is a voltage measured at the terminals of the energy accumulator 21,

$\hat{V}$ is an estimated voltage at the terminals of the energy accumulator 22,

$u$ is the input of the equations system (on the battery model), and corresponds to measurement of the electric current 3 which is circulating through the energy accumulator 2,

$V_{ocv}$ is the open-circuit voltage 10 of the energy accumulator, 2, or more specifically of the battery, estimated during driving.

A, B, C and D are matrices, and are assumed to be known, or to have a tolerable error. These are the parameters which define the energy accumulator model 2, and characterise this model (in particular, each energy accumulator 2 has its own parameters A, B, C, D, with the exception of C which is a vector, and is constant for all the battery models). The errors at B and D are tolerable according to this invention, whereas A must be assumed to be known at all times.

$K$ is a variable 61 which defines a time of convergence of the calculation of the open-circuit voltage 10 of the energy accumulator 2 by means of the observer 41. This time can be reduced to less than a second, and during this period it is necessary to maintain receipt of the electric current measurement 3 with a null value. Otherwise, it is not necessary to carry out any calculation until the condition of the electric current measurement 3 is null for at least the convergence time indicated.

$e_{\hat{V}}$ is a signal which is dependent on a difference between the voltage measured at the terminals of the energy accumulator 21 and the voltage estimated at the terminals of the energy accumulator 22 by the observer 41,

t is the time.

T is the temperature of the battery, on which the values of the parameters of the energy accumulator model depend.

It is important to indicate that the conventional structure of a Luenberger observer 41 is known, and it is used for estimating states in very basic systems, where no unknown functions appear at the output of the model (in the case of the present invention $V_{ocv}$ would be an unknown function which affects the output of the model).

This observer 41 and the subsequent control of its error make it possible to obtain as a result the function which affects the output of the model in question.

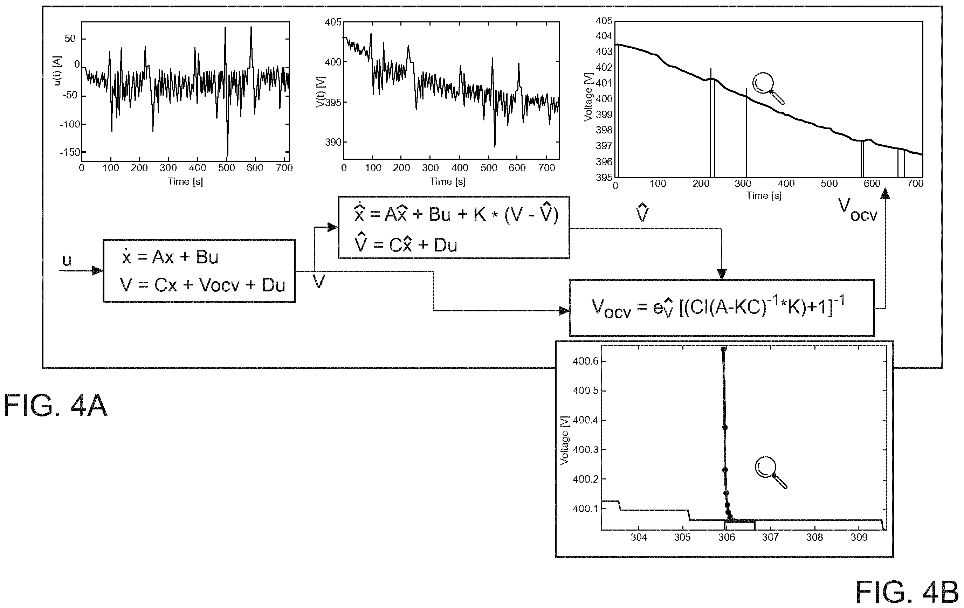

Thus, and as observed in figure 4A, in a conventional Luenberger structure, in order to resupply the system, use is made of the model output estimation error, which in the present case is equivalent to $V$ - $\hat{V}$, multiplied by a constant (which in this case would be equivalent to K). The resupply of the observer 41 structure follows the conventional architecture. Expressed in algebraic form, the observer structure proposed for the energy accumulator 2 is:

$$\dot{\hat{x}} = A\hat{x} + Bu + K(V - \hat{V})$$

$$\hat{V} = C\hat{x} + Du$$

The conventional structure of a Luenberger observer is traditionally used for calculation of the vector of states (x) of a system, or mathematical model, based on the following formulation:

$$\dot{x} = Ax + Bu$$

$$y = Cx$$

where, in the present method, "y" would be equivalent to the voltage "V" of the energy accumulator 2, or more particularly the motor vehicle 1 battery.

However, the formulation of the mathematical model of the battery, represented in figure 6, does not have a form which corresponds to the system previously described (the conventional one on which the Luenberger system is based). For this reason, the calculation of the vector of states estimated using the method described here ($\hat{x}$) does not coincide with the vector of states of the plan (x). However, the proposed combination of the error in estimation of the voltage at the terminals of the accumulator ($e_{\hat{V}} = V$ - $\hat{V}$) makes it possible to determine the aforementioned function $V_{ocv}$. Once this function $V_{ocv}$ is known, it is simple to use an equivalence table in order to obtain the state of charge at the moment when the correction is carried out.

The manner of combining the error $e_{\hat{V}}$ with the other parameters of the model is as follows:

$$V_{OCV} = e_{\hat{V}}\left[\left(CI(A - KC)^{-1}K\right) + 1\right]^{-1}$$

Thus, this method can estimate the function $V_{ocv}$ with precision, without having needed in the calculation process prior knowledge of the vector (x) of the variables of state. To summarise, the innovative form of application of this method makes it possible to estimate a non-measurable characteristic of the battery in any type of situation, including in a non-ideal situation (such as, in particular, during driving, without previously knowing the state of the battery (a condition caused by resetting, or a loss of memory of the computer unit of the motor vehicle 1), including when there are modelling errors in the descriptive parameters).

In addition, it can be observed that the method according to the present invention has the advantage of ensuring precision of the results, irrespective of the state of the battery and/or its time of use, since it is dependent on measurements of the battery itself, i.e. V, I and Ta (voltage, current and temperature).

Furthermore, this method makes it possible to observe the function $V_{ocv}$ without prior knowledge of the initial state of the energy accumulator 2, or the battery, or the battery cell, without needing any uncertain mathematical approximation and without being in a specific highly determining situation, such as when the vehicle has been stopped for a prolonged period of time.

More specifically, the voltage estimated at the terminals of the energy accumulator 22 by the control structure of the observer 41 is obtained according to the formula:

$$\hat{V} = C\hat{x} + Du$$

where $\hat{x}$ is a variable which defines at least one state of the energy accumulator 2 estimated by the observer 41.

It should be noted that the variable which defines at least one state can be both scalar and a vector and is not limited to one of the two. "At least one state" can be a single one, in the scalar case, or a plurality, in the case of the vector.

According to the method of the invention, the variable which defines at least one state of the energy accumulator estimated $\hat{x}$ is calculated by solving a first differential equation of the type:

$$\dot{\hat{x}} = A\hat{x} + Bu + K * (V - \hat{V})$$

where $\dot{\hat{x}}$ is the temporal derivative of the variable which defines at least one state of the energy accumulator 2 estimated $\hat{x}$.

This method provides advantages such as:

- greater speed in obtaining the result compared with the present methods:
- greater precision in calculation of other parameters of the battery or energy accumulator 2 (SoC, current limits, etc.). When basic methods are used for estimating the state of charge, which require periodic corrections to cumulative errors, the present invention has the qualities necessary for good functioning of these estimations in the case of the automotive industry.

- robustness, simplicity and reliability, in the sense that it does not have disadvantages when defining complicated parameters in order for it to function, or in relation to the input data used, since it is valid for any type of situation, whether ideal (in particular with the motor vehicle 1 which has been stationary for a long period of time, meaning that there is no current applied in its battery circuit), or non-ideal (in particular with the motor vehicle 1 running, and therefore having current circulating through its battery circuit, since only one null current condition is necessary for a short period of time). It is also observed that even when there are errors in the parameters of the model, the error of estimation of $V_{ocv}$ is substantially null.

According to an aspect of the invention, the predetermined period of time is at least one second. Preferably, the predetermined period of time is substantially one second.

It should be noted that the energy accumulator 2 is at least one cell of a battery.

According to a preferred embodiment of the invention, the energy accumulator 2 is a battery of a motor vehicle 1.

It is indicated that, as observed in figure 1, the method according to the present invention can be used both for measurements for a low-voltage, or small, battery or energy accumulator 2, and for a high-voltage, or larger, battery or energy accumulator 2. The small one would be the typical battery of any motor vehicle 1 driven by fossil fuel. The large one would be the case of a battery to drive an electric or hybrid vehicle.

In addition, as can be seen from figures 1 and 4, the present invention also comprises a graphic representation device 5 which shows information relating to an open-circuit voltage 10 of an energy accumulator 2 $V_{ocv}$, wherein the open-circuit voltage 10 of an energy accumulator 2 is calculated in accordance with the method of the present invention.

By this means, the information displayed can be both the device's own information $V_{ocv}$, and any other associated information, such as a state of charge of the energy accumulator 2, or a graphic element representing it, which is estimated according to the $V_{ocv}$ calculated according to the above-described method.

Advantageously, the graphic representation device 5 which shows information relating to an open-voltage circuit 10 of an energy accumulator 2 is a screen of a motor vehicle 1, such that the user can easily access the information about the state of the energy accumulator 2 of his motor vehicle 1, from his driving position.

An object of protection is also a data processing device which comprises means for executing the steps of the method for calculation of an open-circuit voltage 10 in accordance with the method of the present invention.

In addition, an object of protection is also a computer programme which comprises instructions in order, when the programme is executed by a computer, to execute the method for calculation of an open-circuit voltage 10 in accordance with the method of the present invention.

It should be noted that the method for calculation of an open-circuit voltage of an energy accumulator is easy to implement, with low consumption of RAM/ROM memory, and the possibility of rapid calculation without advanced hardware.

The details, forms, dimensions and other accessory elements, as well as the components used in the implementation of the method for calculation of an open-circuit voltage of an energy accumulator and associated graphic representation device can conveniently be substituted by others which are technically equivalent, and do not depart from the essential nature of the invention or from the context defined by the claims which are included after the following list.

**List of numerical references:**

| | |
|---|---|
| 1 | motor vehicle |
| 10 | open-circuit voltage $V_{ocv}$ |
| 11 | estimated open-circuit voltage $V_{ocv}$ |
| 2 | energy accumulator |
| 20 | signal $e_{\hat{V}}$ |
| 21 | voltage measured at the terminals of the energy accumulator $V$ |
| 22 | estimated voltage at the terminals of the energy accumulator $\hat{V}$ |
| 3 | electric current measurement $u$ |
| 41 | observer |
| 5 | graphic representation device |
| 61 | variable $K$ |
| 8 | additional device |

**Claims**

1.  Method for estimating a state of charge of an energy accumulator (2), wherein the method is executed by means of a data processing device, **characterised in that** the method comprising the following steps:

    i) establishing a definition for the energy accumulator (2) according to a system of equations and a plurality of descriptive parameters in accordance with the following equation:

$$\dot{x} = Ax + Bu$$

$$V = Cx + Vocv + Du$$

where x is a variable which defines at least one state of the energy accumulator (2), $\dot{x}$ is the temporal derivative of the variable which defines at least one state of the energy accumulator (2) x, A, B, C and D are a plurality of matrices which constitute the performance of the energy accumulator (2), u is a measurement of electric current (3) which circulates through the energy accumulator (2), $V$ is a voltage measured at the terminals of the energy accumulator (21), and $V_{ocv}$ is an open-circuit voltage (10) of the energy accumulator (2);

ii) obtaining the measurement of the electric current $u$ (3) which circulates through the energy accumulator (2);

iii) determining on the basis of the electric current measurement $u$ (3) obtained that the open-circuit voltage $V_{ocv}$ (10) of the energy accumulator (2) is constant for a predetermined period of time; wherein open-circuit voltage $V_{ocv}$ (10) of the energy accumulator (2) is determined to be constant whenever the electric current measurement $u$ (3) obtained is equal to zero during the predetermined period of time;

iv) obtaining the voltage measured at the terminals of the energy accumulator $V$ (21) when the open-circuit voltage $V_{ocv}$ (10) is determined constant for the predetermined period of time;

v) calculating an estimated voltage at the terminals of the energy accumulator $\hat{V}$ (22) by means of an observer (41), wherein the observer (41) is defined by means of a specific control structure; wherein the estimated voltage at the terminals of the energy accumulator $\hat{V}$ (22) by the control structure of the observer (41) is obtained according to the formula:

$$\hat{V} = C\hat{x} + Du$$

where $\hat{x}$ is a variable which defines at least one state of the energy accumulator (2) estimated by the observer (41), and wherein the variable which defines at least one estimated state of the energy accumulator (2) $\hat{x}$ is calculated by solving a first differential equation of the type:

$$\dot{\hat{x}} = A\hat{x} + Bu + K * (V - \hat{V})$$

where $\dot{\hat{x}}$ is the temporal derivative of the variable which defines at least one estimated state of the energy accumulator (2) $\hat{x}$.

vi) calculating the open-circuit voltage $V_{ocv}$ (10) of the energy accumulator (2) by means of the formula:

$$V_{OCV} = e_{\hat{V}}\left[\left(CI(A - KC)^{-1}K\right) + 1\right]^{-1}$$

where $e_{\hat{V}}$ is a signal (20) which depends on a difference between the voltage measured at the terminals of the energy accumulator $V$ (21) and the estimated voltage at the terminals of the energy accumulator $\hat{V}$ (22) by the observer (41), and $\_K$ is a variable (61) which defines a time of convergence of the calculation of the open-circuit voltage $V_{ocv}$ (10) of the energy accumulator (2) by means of the observer (41); and

vii) estimating the state of charge of the energy accumulator (2), by means of the estimated open-circuit voltage $V_{ocv}$ (11) and a characteristic table, wherein the characteristic table relates the open-circuit voltage $V_{ocv}$ (10) to the state of charge.

2. Method according to Claim 1, **characterized in that** obtaining the value of the electric current measurement $u$ (3) which is equal to zero consists of forcing an interruption of a first electrical supply by the energy accumulator (2) during the predetermined period of time.

3. Method according to Claim 2, **characterized in that** forcing the interruption of the first electrical supply by the energy accumulator (2) consists of providing a second electrical supply by means of an additional device (8) during the predetermined period of time, such that an electric current supplied by the energy accumulator (2) and by the additional device (8) is continuous.

4. Method according to Claim 1, **characterized in that** the predetermined period of time is at least one second.

5. Method according to Claim 1, **characterized in that** the predetermined period of time is one second.

6. Method according to Claim 1, **characterized in that** the energy accumulator (2) is at least one cell of a battery.

7. Method according to Claim 1, **characterized in that** the energy accumulator (2) is a battery of a motor vehicle (1).

8. Data processing device which comprises means for executing the steps of the method for estimating a state of charge of an energy accumulator (2) in accordance with Claims 1-7.

9. Data processing device of claim 8 further including a graphic representation device (5) which shows information relating to the state of charge of the energy accumulator.

10. Data processing device of claim 9; wherein the graphic representation device (5) is a screen of a motor vehicle (1).

11. Computer program which comprises instructions in order, when the program is executed by a computer, to execute the method estimating a state of charge of an energy accumulator (2) in accordance with Claims 1-7.

**Patentansprüche**

1. Verfahren zum Schätzen eines Ladezustands eines Energieakkumulators (2), wobei das Verfahren mittels einer Datenverarbeitungsvorrichtung ausgeführt wird, **dadurch gekennzeichnet, dass** das Verfahren die folgenden Schritte umfasst:

i) Feststellen einer Definition für den Energieakkumulator (2) gemäß einem System von Gleichungen und mehreren beschreibenden Parametern nach der folgenden Gleichung:

$$\dot{x} = Ax + Bu$$

$$V = Cx + Vocv + Du$$

wobei x eine Variable ist, die mindestens einen Zustand des Energieakkumulators (2) definiert, $\dot{x}$ die zeitliche Ableitung der Variablen, die mindestens einen Zustand des Energieakkumulators (2) definiert, $x$ ist, A, B, C und D mehrere Matrizen sind, welche die Leistung des Energieakkumulators (2) bilden, $u$ ein Messwert des elektrischen Stroms (3) ist, der durch den Energieakkumulator (2) zirkuliert, $V$ eine Spannung ist, die an den Anschlüssen des Energieakkumulators gemessen wird (21), und $V_{ocv}$ eine Ruhespannung (10) des Energieakkumulators (2) ist,
ii) Gewinnen des Messwerts des elektrischen Stroms $u$ (3), der durch den Energieakkumulator (2) zirkuliert,
iii) Bestimmen auf der Basis des gewonnenen Messwertes des elektrischen Stroms $u$ (3), dass die Ruhespannung $V_{ocv}$ (10) des Energieakkumulators (2) für eine festgelegte Zeitperiode konstant ist, wobei die Ruhespannung $V_{ocv}$ (10) des Energieakkumulators (2) als konstant bestimmt wird, immer wenn der gewonnene Messwert des elektrischen Stroms $u$ (3) während der festgelegten Zeitperiode gleich Null ist,
iv) Gewinnen der Spannung, die an den Anschlüssen des Energieakkumulators gemessen wird, $V$ (21), wenn die Ruhespannung $V_{ocv}$ (10) des Energieakkumulators als konstant für die festgelegte Zeitperiode bestimmt wird,
v) Berechnen einer geschätzten Spannung an den Anschlüssen des Energieakkumulators $\hat{V}$ (22) mittels eines Beobachters (41), wobei der Beobachter (41) mittels einer spezifischen Steuerstruktur definiert ist, wobei die geschätzte Spannung an den Anschlüssen des Energieakkumulators $\hat{V}$ (22) durch die Steuerstruktur des Beobachters (41) gemäß der folgenden Formel gewonnen wird:

$$\hat{V} = C\hat{x} + Du$$

wobei $\hat{x}$ eine Variable ist, die mindestens einen Zustand des Energieakkumulators (2) definiert, der durch den Beobachter (41) geschätzt wird, und wobei die Variable, die mindestens einen Zustand des Energieakkumulators (2) definiert, $\hat{x}$ durch Lösen einer ersten Differenzialgleichung des folgenden Typs berechnet wird:

$$\dot{\hat{x}} = A\hat{x} + Bu + K * (V - \hat{V})$$

wobei $\dot{\hat{x}}$ die zeitliche Ableitung der Variablen ist, die mindestens einen geschätzten Zustand des Energieakkumulators (2) definiert, $\hat{x}$,
vi) Berechnen der Ruhespannung $V_{ocv}$ (10) des Energieakkumulators (2) mittels der folgenden Formel:

$$V_{ocv} = e_{\hat{V}}[(CI(A - KC)^{-1}K) + 1]^{-1}$$

wobei $e_{\hat{V}}$ ein Signal (20) ist, das von einer Differenz zwischen der Spannung, die an den Anschlüssen des Energieakkumulators gemessen wurde, $V$(21) und der durch den Beobachter (41) geschätzten Spannung an den Anschlüssen des Energieakkumulators $\hat{V}$ (22) abhängt, und $K$ eine Variable (61) ist, die eine Zeit der Konvergenz der Berechnung der Ruhespannung $V_{ocv}$ (10) des Energieakkumulators (2) mittels des Beobachters (41) definiert, und
vii) Schätzen des Ladezustands des Energieakkumulators (2) mittels der geschätzten Ruhespannung $V_{ocv}$ (11) und einer Kennwerttabelle, wobei die Kennwerttabelle die Ruhespannung $V_{ocv}$ (10) mit dem Ladezustand in Beziehung setzt.

2. Verfahren nach Anspruch 1, **dadurch gekennzeichnet, dass** das Gewinnen des Wertes des Messwertes des elektrischen Stroms $u$ (3), der gleich Null ist, aus dem Erzwingen einer Unterbrechung einer ersten elektrischen Versorgung durch den Energieakkumulator (2) während der festgelegten Zeitperiode besteht.

3. Verfahren nach Anspruch 2, **dadurch gekennzeichnet, dass** das Erzwingen der Unterbrechung der ersten elektrischen Versorgung durch den Energieakkumulator (2) aus dem Bereitstellen einer zweiten elektrischen Versorgung mittels einer zusätzlichen Vorrichtung (8) während der festgelegten Zeitperiode besteht, sodass ein elektrischer Strom, der durch den Energieakkumulator (2) und durch die zusätzliche Vorrichtung (8) zugeführt wird, kontinuierlich ist.

4. Verfahren nach Anspruch 1, **dadurch gekennzeichnet, dass** die festgelegte Zeitperiode mindestens eine Sekunde beträgt.

5. Verfahren nach Anspruch 1, **dadurch gekennzeichnet, dass** die festgelegte Zeitperiode eine Sekunde beträgt.

6. Verfahren nach Anspruch 1, **dadurch gekennzeichnet, dass** der Energieakkumulator (2) mindestens eine Zelle einer Batterie ist.

7. Verfahren nach Anspruch 1, **dadurch gekennzeichnet, dass** der Energieakkumulator (2) eine Batterie eines Kraftfahrzeugs (1) ist.

8. Datenverarbeitungsvorrichtung, die Mittel zum Ausführen der Schritte des Verfahrens zum Schätzen eines Ladezustands eines Energieakkumulators (2) gemäß Anspruch 1-7 umfasst.

9. Datenverarbeitungsvorrichtung nach Anspruch 8, ferner eine Vorrichtung zur grafischen Darstellung (5) beinhaltend, die Informationen bezüglich des Ladezustands des Energieakkumulators zeigt.

10. Datenverarbeitungsvorrichtung nach Anspruch 9, wobei die Vorrichtung zur grafischen Darstellung (5) ein Bildschirm eines Kraftfahrzeugs (1) ist.

11. Computerprogramm, das Anweisungen umfasst, damit bei Ausführung des Programms durch einen Computer das Verfahren, das einen Ladezustand eines Energieakkumulators (2) schätzt, nach den Ansprüchen 1 bis 7 ausgeführt wird.

## Revendications

1. Procédé d'estimation d'un état de charge d'un accumulateur d'énergie (2), dans lequel le procédé est exécuté à l'aide d'un dispositif de traitement de données, **caractérisé en ce que** le procédé comprend les étapes suivantes:

i) établir une définition pour l'accumulateur d'énergie (2) selon un système d'équations et une pluralité de paramètres descriptifs en fonction de l'équation suivante:

$$\dot{x} = Ax + Bu$$

$$V = Cx + Vocv + Du$$

où x est une variable qui définit au moins un état de l'accumulateur d'énergie (2), $\dot{x}$ est la dérivée temporelle de la variable qui définit au moins un état de l'accumulateur d'énergie (2), x, A, B, C et D dont une pluralité de matrices qui constituent la performance de l'accumulateur d'énergie (2), $u$ est une mesure du courant électrique (3) qui circule à travers l'accumulateur d'énergie (2), $V$ est une tension mesurée aux bornes de l'accumulateur d'énergie (21), et $V_{ocv}$ est une tension en circuit ouvert (10) de l'accumulateur d'énergie (2);
ii) obtenir la mesurer du courant électrique $\underline{u}$ (3) qui circule à travers l'accumulateur d'énergie (2);
iii) déterminer, sur la base de la mesure du courant électrique $u$ (3) obtenue, que la tension en circuit ouvert $V_{ocv}$ (10) de l'accumulateur d'énergie (2) est constante pendant une durée prédéterminée; dans lequel la tension en circuit ouvert $V_{ocv}$ (10) de l'accumulateur d'énergie (2) est déterminée comme étant constante lorsque la mesure du courant électrique $\underline{u}$ (3) obtenue est égale à zéro pendant la durée prédéterminée;
iv) obtenir la tension mesurée aux bornes de l'accumulateur d'énergie $V$ (21) lorsque la tension en circuit ouvert $V_{ocv}$ (10) est déterminée comme constante pendant la durée prédéterminée;
v) calculer une tension estimée aux bornes de l'accumulateur d'énergie $\hat{V}$ (22) à l'aide d'un observateur (41), dans lequel l'observateur (41) est défini à l'aide d'une structure de commande spécifique ; dans lequel la tension estimée aux bornes de l'accumulateur d'énergie $\hat{V}$ (22) par la structure de commande de l'observateur (41) est obtenue selon la formule:

$$\hat{V} = C\hat{x} + Du$$

où $\hat{x}$ est une variable qui définit au moins un état de l'accumulateur d'énergie (2) estimé par l'observateur (41), et dans lequel la variable qui définit au moins un état estimé de l'accumulateur d'énergie (2) $\hat{x}$ est calculée en résolvant une première équation différentielle du type:

$$\dot{\hat{x}} = A\hat{x} + Bu + K * (V - \hat{V})$$

où $\dot{\hat{x}}$ est la dérivée temporelle de la variable qui définit au moins un état estimé de l'accumulateur d'énergie (2) $\dot{\hat{x}}$ ;

vi) calculer la tension en circuit ouvert $V_{ocv}$ (10) de l'accumulateur d'énergie (2) à l'aide de la formule:

$$V_{ocv} = e_{\hat{V}}[(CI(A - KC)^{-1}K) + 1]^{-1}$$

où $e_{\hat{V}}$ est un signal (20) qui dépend d'une différence entre la tension mesurée aux bornes de l'accumulateur d'énergie $V$ (21) et la tension estimée aux bornes de l'accumulateur d'énergie $\hat{V}$ (22) par l'observateur (41), et $K$ est une variable (61) qui définit une durée de convergence du calcul de la tension en circuit ouvert $V_{ocv}$ (10) de l'accumulateur d'énergie (2) à l'aide de l'observateur (41); et

vii) estimer l'état de charge de l'accumulateur d'énergie (2), à l'aide de la tension en circuit ouvert estimée $V_{ocv}$ (11) et d'une table de caractéristiques, dans lequel la table de caractéristiques associe la tension en circuit ouvert $V_{ocv}$ (10) à l'état de charge.

2. Procédé selon la revendication 1, **caractérisé en ce que** l'obtention de la valeur de la mesure du courant électrique u (3) qui est égale à zéro consiste à forcer une interruption d'une première alimentation en électricité par l'accumulateur d'énergie (2) pendant la durée prédéterminée.

3. Procédé selon la revendication 2, **caractérisé en ce que** le fait de forcer l'interruption de la première alimentation en électricité par l'accumulateur d'énergie (2) consiste à fournir une seconde alimentation en électricité à l'aide d'un dispositif supplémentaire (8) pendant la durée prédéterminée, de sorte qu'un courant électrique fourni par l'accumulateur d'énergie (2) et par le dispositif supplémentaire (8) soit continu.

4. Procédé selon la revendication 1, **caractérisé en ce que** la durée prédéterminée est d'au moins une seconde.

5. Procédé selon la revendication 1, **caractérisé en ce que** la durée prédéterminée est d'une seconde.

6. Procédé selon la revendication 1, **caractérisé en ce que** l'accumulateur d'énergie (2) est au moins une cellule d'une batterie.

7. Procédé selon la revendication 1, **caractérisé en ce que** l'accumulateur d'énergie (2) est une batterie d'un véhicule à moteur (1).

8. Dispositif de traitement de données qui comprend un moyen destiné à exécuter les étapes du procédé d'estimation d'un état de charge d'un accumulateur d'énergie (2) selon les revendications 1 à 7.

9. Dispositif de traitement de données selon la revendication 8, comprenant en outre un dispositif de représentation graphique (5) qui affiche des informations relatives à l'état de charge de l'accumulateur d'énergie.

10. Dispositif de traitement de données selon la revendication 9; dans lequel le dispositif de représentation graphique (5) est un écran d'un véhicule à moteur (1).

11. Programme informatique qui comprend des instructions destinées à, lorsque le programme est exécuté par un ordinateur, exécuter le procédé d'estimation d'un état de charge d'un accumulateur d'énergie (2) selon les revendications 1 à 7.

FIG. 1

FIG. 2

FIG. 3

EP 3 343 389 B1

FIG. 4A

FIG. 4B

EP 3 343 389 B1

FIG. 5

EP 3 343 389 B1

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20150219726 A
- US 8099180 B
- EP 0505333 A
- US 7109685 B

### Non-patent literature cited in the description

- Luenberger observer for SoC determination of lithium-ion cells in mild hybrid vehicles, compared to a Kalman filter. 2015 Tenth International Conference on Ecological Vehicles and Renewable Energies (EVER). IEEE, 31 March 2015, 1-7